Europäisches Patentamt

European Patent Office

Office européen des brevets

(19)

(11) **EP 0 725 348 A1**

(12) **EUROPEAN PATENT APPLICATION**

(43) Date of publication:
07.08.1996 Bulletin 1996/32

(51) Int. Cl.$^6$: **G06F 12/10**, G11C 15/04

(21) Application number: **96101054.3**

(22) Date of filing: **25.01.1996**

(84) Designated Contracting States:
**DE FR GB**

(30) Priority: **02.02.1995 US 382719**

(71) Applicant: **MOTOROLA, INC.**
Schaumburg, IL 60196 (US)

(72) Inventors:
• **Maguire, Jeffrey E.**
Austin, Texas 78704 (US)

• **Moyer, William C.**
Dripping Springs, Texas 78680 (US)
• **Ho, Yui Kaye**
Austin, Texas 78746 (US)

(74) Representative: **Hudson, Peter David et al**
Motorola,
European Intellectual Property Operations,
Midpoint
Alencon Link
Basingstoke, Hampshire RG21 1PL (GB)

(54) **A data processor comprising look aside buffer and method therefor**

(57) A method and apparatus for performing a memory mapping operation in a data processing system (10); wherein, one CAM array is capable of support-ing multiple page sizes through the use of valid bits to control portions of a memory array.

FIG.5

## Description

### FIELD OF THE INVENTION

The present invention relates in general to a data processing system, and more particularly to a method and apparatus for performing memory mapping operations in a data processing system.

### BACKGROUND OF THE INVENTION

Today's high performance data processing systems rely upon sophisticated memory management systems to translate logical addresses into real (physical) addresses. Logical addresses are the software addresses used by the programmer when writing software. Physical addresses are the hardware addresses used by the semiconductor chips and electronic circuitry running the software.

In a very simple microprocessor-based system, the central processing unit (CPU) is linked directly to memory. With this type of configuration, no memory mapping or task protection capabilities are provided, and the addresses generated by the CPU directly identify the physical locations to be accessed. This type of system, however, is unsuitable for multiple-task operations since there is no protection to prevent corruption of memory used by one task during execution of another.

A memory unit with one or more translation-lookaside buffers (TLBs) is often used to provide the address mapping and the task protection needed to construct a multitasking data processing system. The memory unit acts as an interface between the CPU and the physical memory. The memory unit controls all accesses to physical devices and tasks can be prevented from accessing the memory resources used by other tasks. When under the control of an operating system with virtual memory capabilities, the logical-to-physical mapping functions allow tasks to utilize the entire address space of the CPU to build a memory system as large as the CPU address space without detailed knowledge of the physical characteristics of the system.

The logical address is generated by an instruction unit or a data unit of the CPU and is received as an input by the memory unit. The memory unit, using one or more TLBs, performs address translation and privilege checking for the logical address and, if the mapping is valid, drives the corresponding physical address to the data or instruction cache or some other type of memory. Note that the corresponding physical address produced by a TLB may be used to access either data or an instruction, depending upon whether the TLB is part of a data memory unit or part of an instruction memory unit.

Generally, a memory unit contains one or more TLBs which are used to perform address translation and privilege checking; the memory unit also contains one or more caches which store actual data or instructions. Each entry in the TLB usually contains a logical address, a corresponding physical address, and one or more protection or control bits (collectively called attribute bits or attributes).

On each memory access, an incoming logical address is received by the memory unit and is compared to the logical address portion of each entry in the appropriate TLB in order to locate the requisite logical-to-physical mapping. When the TLB contains the requisite logical-to-physical mapping, a translation "hit" (also called a "match") occurs, and the TLB produces the corresponding physical address.

When the TLB does not contain the requisite logical-to-physical mapping, a translation "miss" (also called "no match") occurs, and a hardware state machine or a software routine is invoked to search memory more distant than the TLB in order to determine the physical address that corresponds to the received logical address. This search is often called a "table search" or a "table walk" because it may require the data processing system to access and read more than one memory table stored in more distant memory.

The advantage of a TLB is that it saves a great deal of time. Rather than having to access tables in distant memory every time a translation is required, the data processing system can quickly access the TLB and retrieve the correct physical address for certain selected logical addresses.

A cache/memory management unit on the MC88200, available from Motorola, Inc. of Austin, Texas, has a separate memory unit for instructions and a separate memory unit for data. Each of the two memory units (instruction and data) has address translation logic containing a page address translation-lookaside buffer (PTLB) and a separate block address translation-lookaside buffer (BTLB). Both of the buffers may be interchangeably referred to as a cache.

The BTLB provides logical-to-physical address translation for 512K-byte blocks of memory or 512K-byte page sizes. The PTLB, on the other hand, provides logical-to-physical address translation for smaller 4K-byte pages of memory. These systems can be thought of as being capable of translating two fixed pages sizes to and from a physical address. However, each TLB (BTLB and PTLB) comprises circuit hardware and power consumption overhead including sense amps, wordline drivers and control structures. In addition to this overhead, the complexity of an arbitration between the two TLBs is also required.

These systems could handle two fixed pages sizes well. However, it was desirable to support more than two page sizes. Some data processing system applications require large linear arrays of data. For example, a frame buffer for a color monitor may consist of a large linear array of data which corresponds to the pixels on the screen of the monitor. Such a frame buffer may require as much as 4M-bytes of memory. Such a frame buffer would require one thousand (1000) pages if each page was 4K-bytes and eight (8) pages if each page was 512K-bytes. Additionally, object oriented operating systems typically use multiple object sizes.

Extending the current system to multiple page sizes by adding additional TLBs is not practicable. The overhead of adding additional TLBs and the additional complexity of arbitrating between multiple TLBs may be overburdensome.

BRIEF DESCRIPTION OF THE DRAWINGS

The following detailed description taken in conjunction with the accompanying figures are provided to convey an understanding to persons reasonably skilled in the arts necessary to make and use the invention.

FIG. 1     illustrates, in block diagram form, a data processing system 10 in accordance with one embodiment of the present invention;

FIG. 2     illustrates, in block diagram form, a data memory unit 32 of **FIG. 1** in accordance with one embodiment of the present invention;

FIG. 3     illustrates, in block diagram form, an instruction memory unit 40 of **FIG. 1** in accordance with one embodiment of the present invention;

FIG. 4     illustrates, in block diagram form, a portion of memory management unit (MMU) 52 of **FIG. 2**, which is identical to a portion of memory management unit (MMU) 62 of **FIG. 3**, in accordance with one embodiment of the present invention;

FIG. 5     illustrates in block diagram form a translation look aside buffer (TLB) 70 of **FIG. 4** in accordance with one embodiment of the present invention;

FIG. 6     illustrates, in circuit diagram form, a single CAM cell bit (200) in accordance with one embodiment of the present invention;

FIG. 7     illustrates, in circuit diagram form, a single valid bit (128) in accordance with one embodiment of the present invention;

FIGs. 8-11   illustrate components of a physical address generated by the present invention.

DESCRIPTION OF THE PREFERRED EMBODIMENT

A more flexible approach to address translation is desired. More specifically, an approach to address translation which supports multiple page sizes quickly and efficiently is desirable. The use of multiple page sizes results in less wasted memory allocation as well as a reduction in a number of entries that are needed to map a memory. The present invention, disclosed herein, is useful for a wide variety of applications to improve the efficiency and flexibility of data processing systems requiring address translation.

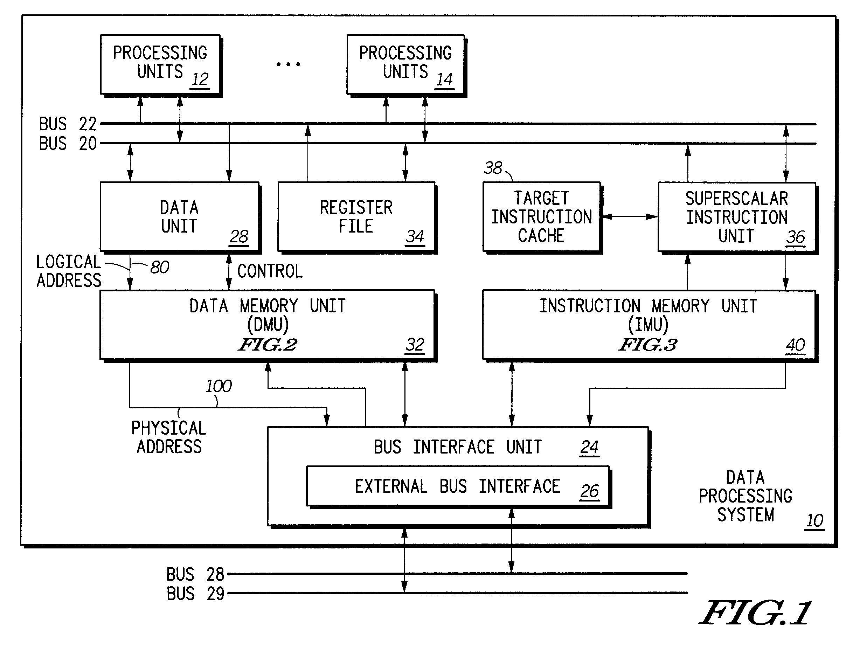

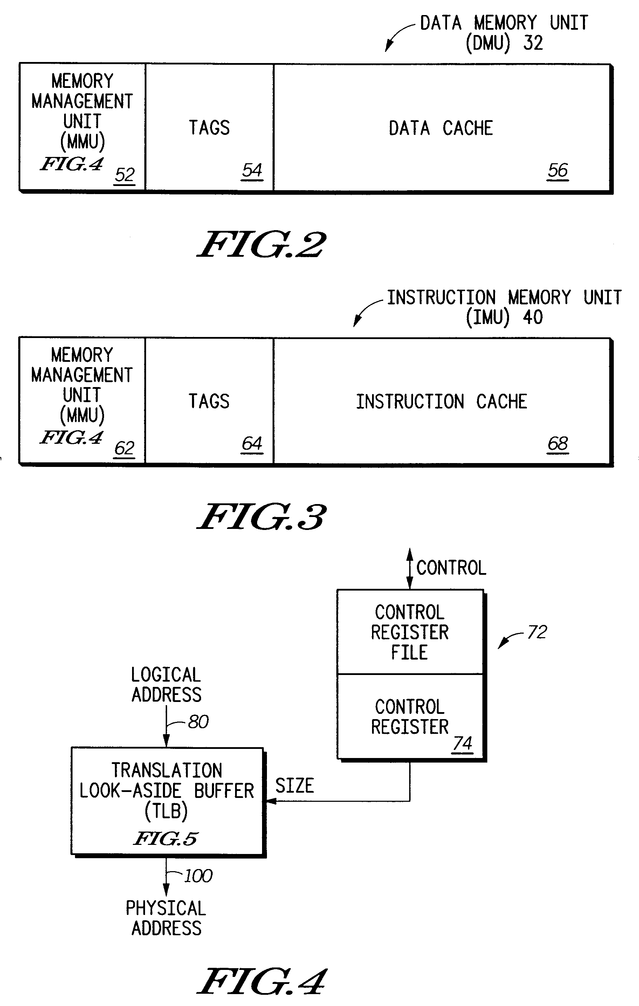

**FIG. 1** illustrates a data processing system 10. Processing units 12 through 14 are bi-directionally coupled to bus 20 and are coupled to bus 22. Data unit 30 is bi-directionally coupled to both bus 20 and data memory unit (DMU) 32. Register file 34 is bi-directionally coupled to bus 20 and is coupled to bus 22 in order to provide signals to bus 22. Instruction unit 36 is bi-directionally coupled to bus 22 and is coupled to bus 20 in order to provide signals to bus 20. Target instruction cache 38 and instruction memory unit (IMU) 40 are each bi-directionally coupled to instruction unit 36. Data memory unit (DMU) 32 is bi-directionally coupled to data unit 30.

Instruction memory unit (IMU) 40 and data memory unit (DMU) 32 are each bi-directionally coupled to bus interface unit 24. Bus interface unit 24 has an external bus interface 26 which is bi-directionally coupled to bus 28 and to bus 29. In one embodiment of the present invention illustrated in **FIG. 1**, data processing system 10 is located on a single integrated circuit, and bus 28 and bus 29 are both external to data processing system 10.

**FIG. 2** illustrates a data memory unit (DMU) circuit 32 of **FIG. 1**. DMU 32 includes a memory management unit (MMU) circuit 52, a tags circuit 54, and a data cache circuit 56. **FIG. 3** illustrates an instruction memory unit (IMU) circuit 40 of **FIG. 1**. IMU 40 includes a memory management unit (MMU) circuit 62, a tags circuit 64, and an instruction cache circuit 66.

**FIG. 4** illustrates a portion of memory management unit (MMU) 52 of **FIG. 2**. Note that in one embodiment of the present invention, the portion of MMU 52 which is illustrated in **FIG. 4** is identical to a portion of memory management unit (MMU) 62 of **FIG. 3.** In other embodiments of the present invention, **FIG. 4** may illustrate a portion of only one memory management unit, or an identical portion of more than one memory management unit.

Still referring to **FIG. 4**, Translation-Lookaside Buffer (TLB) 70 receives a logical address 80 from the data unit 30 of **FIG. 1** or instruction unit 36 of **FIG. 1.** TLB also receives control signals from control register 74 of the control register file 72. A logical address transferred via bus 80 is typically a subset of the address bits from the data unit 30, but could be a whole address from the data unit 30. The TLB 70 then uses the logical address transferred via bus 80 to generate a physical address 100.

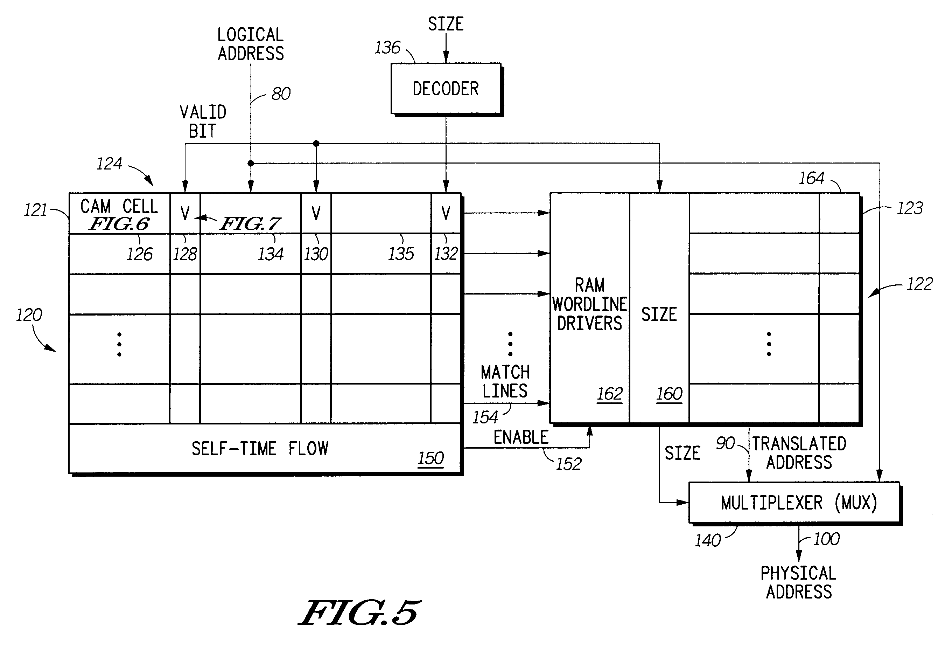

**FIG. 5** illustrates an architecture of the mapping function of a content addressable memory (CAM) array 120 and a RAM array 122 which are implemented in the TLB 70 of **FIG.4** in accordance with one embodiment of the present invention. The mapping function enables translation between the logical address 80 and physical address 100. Each row 121 of the array 120 is partitioned into multiple column parings 124. Each pairing comprises a CAM cell group 126 which includes one or more CAM cell bits 200 of FIG. 6 and a valid bit 128. Similar pairings include CAM cell group 134 and valid bit 130 and CAM cell group 135 and valid bit 132. Although not shown in detail in **FIG. 5**, each CAM cell group 126 includes a plurality of CAM cell bits such as CAM cell bit 200 illustrated in FIG. 6. **FIG. 5** includes three pairings per row of CAM array 120 and, therefore, can support three page sizes. In other embodiments of the invention, the CAM array 120 can be partitioned into any multiple of CAM cell group 126 and valid bit 128 pairings. Although the CAM cell groups 126, 134, and 135 are shown in **FIG. 5** to be roughly equivalent in size, in other embodiments of the invention a number of CAM cell bits (not shown) in each CAM cells group 126 can differ from pairing to pairing, but are constant within each pairing for all of the rows 121 except possibly a last row 150 of the CAM array.

It should be understood that in the embodiment of the invention shown and described herein, the bits of CAM cell group (not shown in detail) to the right are more significant and the bits to the left are less significant.

The page size translated to a physical address 100 is determined by a portion of the logical address transferred via 80 which is matched to the address stored in the CAM cell groups 126, 134, and 135 in each row 121 of the CAM array 120. The portion of the logical address 80 is compared to or matched with an address stored in the CAM cell groups 126, 134, and 135 is determined by the status of the valid bits 128, 130 and 132 in a row of CAM array 120. If the valid bit 128 in a CAM cell pairing 124 is asserted, then the address bits stored in that CAM cell group 126 will be matched to the portion of the logical address transferred via bus 80 corresponding to that CAM cell group. For one page size, all three valid bits 128, 130, and 132 in a row of CAM array 120 are asserted. For a second page size, the two right-most valid bits 130 and 132 are asserted and the left-most valid bit 128 is not asserted. In this situation, the information in CAM cell group 126 is considered to be in a "don't care" region of the CAM array row 121. For the third page size the right-most valid bit in a row 121 is asserted, the left-most valid bits 128 and 130 are not asserted, and the information in each of CAM cell groups 126 and 134 is in the "don't care" region of the CAM array row 121.

In the embodiment of the invention illustrated herein, when a first valid bit to the left of a second valid bit is asserted, the second valid bit is also asserted. For example if valid bit 128 is asserted then valid bits 130 and 132 must also be asserted. Likewise, if valid bit 130 is asserted, then valid bit 132 must be asserted.

Embodiments employing other configurations may also be possible.

The status of the valid bits is determined by decoder 136. Decoder 136 receives page size information from the control register 74 of the control register file 72. Decoder 136 also provides page size data information to a page size register 160, illustrated as a column of the RAM array 122 in **FIG. 5**. In this embodiment of the invention, the last row 150 of the CAM array 120 performs a self-timing or delay function. Last row 150 provides an enable signal 152 to a plurality of wordline drivers 162 of RAM array 122. The enable signal enables the plurality of wordline drivers 162 to read the information provided by the plurality of s match lines 154 of the CAM array 120.

When the CAM array 120 and RAM array 122 are configured, data is stored in the CAM cell bits (not shown) representative of translated addresses corresponding to each possible logical address. Each row 121 in the CAM array 120 represents one logical address and is connected via one of the plurality of match lines 154 to a corresponding row 123 in the RAM array 122. During operation, the logical address transferred via bus 80 which is to be translated is compared to the possible logical addresses in each row of CAM array 120 in order to obtain a match. If a match is found, a one of the plurality of the match lines 154 corresponding to row 121 is asserted and all non-matched row match lines 154 are not asserted. The self time row 150 then provides an enable signal 152 which indicates that the matching function is complete in all of the CAM array rows 121. If one of the plurality of match lines 154 and the enable signal 152 are both asserted, then one of the plurality RAM array wordline drivers 162 will select the appropriate row in the RAM array 122.

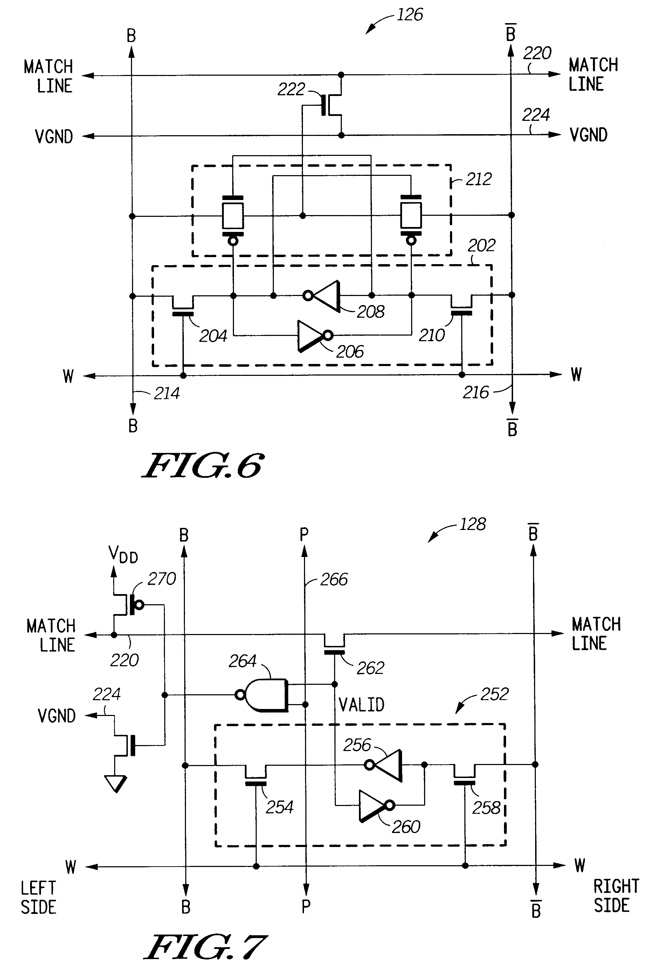

**FIG. 7** and **FIG. 6** and the description provided in the following description explain how the CAM array 120 matches the logical address provided via bus 80 with possible logical addresses stored in the CAM array 120. As was previously explained, each row 121 in the CAM array 120, includes a plurality of CAM cell bits and valid bits. **FIG. 6** illustrates a CAM cell bit circuit 200 which is used to compare a bit of the input logical address provided by bus 80 and a stored possible logical address. **FIG. 7** illustrates a valid bit circuit 128 which is used to determine whether the CAM cell bits to its left should be accessed during the matching function.

Both CAM cell bits and valid bits include a static memory cell 202 and 252, respectively. The embodiments illustrated in **FIGs. 6** and **7** contain six transistor static RAM memory cells (6T SRAM). A person reasonably skilled in the art will recognize components 204, 206, 208 and 210 in **FIG. 6** and 254, 256, 258 and 260 in **FIG. 7** as the 6T SRAM memory cells. It should be noted that other embodiments are possible. These memory cells 202 and 252 store the bits of possible logical addresses and valid bit values against which the input logical address transferred via bus 80 will be matched.

The CAM bit circuit 200 also includes circuitry 212 for performing a logical EXCLUSIVE-OR between the value stored in the memory cell 202 and the logic address bit value on bit line, b, 214 and inverted bit line, $\overline{b}$, 216.

Before the matching function is initiated, the match line 220 is asserted. Match line 220 forms a portion of one of the plurality of match lines 154 of FIG. 5. If the EXCLUSIVE-OR circuitry 212 indicates a match between the value on the bit lines 214 and 216 and the value stored in memory cell 202, then transistor 222 will not be conductive and the match line 220 remains asserted. However, if EXCLUSIVE-OR circuitry 212 finds a mis-match, then transistor 222 will be conductive and the match line 220 will be pulled to a non-asserted state using the *vgnd* 224 line value. The *vgnd* 224 line value is pulled to a reference ground value using transistor 268 in valid bit 128 of FIG. 7. If any of the bits in CAM cell group 126 of **FIG. 5** for which the valid bit has been asserted indicates a mismatch, then a corresponding one of the plurality of match lines 154 for the row in which the bit is implemented is pulled to a non-asserted state.

However, if the valid bit 128 for a CAM cell group 126 is not asserted, then the match line 220 in the plurality of CAM cell bits of CAM array 120 in CAM cell group 126 are isolated from a remaining portion of the plurality of the match lines 154 used to access the RAM array 122. Transistor 262 is capable of isolating the portion of the match line 220 to the left of the valid bit 128 if the valid bit 128 is not asserted (in this case, a logic low value or a "0"). In this way, the valid bit 128 controls a portion of the CAM array row 121 (illustrated in **FIG. 5**) which will participate in the matching of the logical address transferred via bus 80 and transferred to CAM array 120 via bit lines 214 and 216. If the valid bit 128 is not asserted, then all information in the plurality of CAM cell bits to the left of the valid bit will not be matched to the logical address transferred via bus 80. On the other hand, if a valid bit 128 is asserted, the plurality of CAM cell bits to the left of the valid bit will be included in the matching function until a non-asserted valid bit isolates a plurality of CAM cell bits to its left. The isolated CAM cell bits are in the "don't care" region of the CAM array row 121.

If the valid bit 128 is not asserted, then an output of NAND gate 264 will be asserted regardless of the value on the *p* input line 266. When the output of NAND gate 264 is asserted, transistor 268 is conductive and enables the *vgnd* signal 224 to be pulled to the reference ground voltage. Referring to **FIG. 6**, if there is no match between the value stored in CAM bit memory cell 202 of CAM cell bit 200 and the bit line, b, 214 value, then the "don t care" region of the match line 220 will be pulled to the reference ground voltage via the *vgnd* signal 224. If there is a match between the value stored in CAM bit memory cell 202 of CAM cell bit 200 and the bit line, b, 214 value, then the "don't care" region of the match line 220 will not be pulled to the reference ground voltage, but it will not affect the match line 220 value to the right of the valid bit 128 since transistor 262 effectively isolates match line 220 to its left. Since transistor 270 remains non-conductive and transistor 268 remains conductive when the valid bit is not asserted, no power is consumed in the "don't care" region when a mismatch occurs.

If the valid bit is asserted (a logic high value or a "1", in this embodiment of the invention), then the output NAND gate 264 will be determined by the *p* input line 266 value. When *p* input line 266 is asserted, the match line 220 is precharged to a supply voltage, Vdd, through transistor 270 while transistor 268 remains non-conductive. Transistor 270 also precharges the *vgnd* signal 224 through transistor 222 of CAM bit cell 200 illustrated in FIG. 6 to Vdd - Vt. Vt is the threshold voltage of the n-channel transistors. When *p* input line 266 is not asserted, *vgnd* signal is pulled to a logic low value using transistor 268. Match line 220 is also pulled to a logical low value through transistor 222 if a mismatch is determined in CAM bit 200. The match line to the right of valid bit 128 is then pulled to a logic low value using transistor 262. If a match occurs, match line 220 does not get pulled to a logic low value through transistor 222 of each of the plurality of CAM cells bits 200 to the left of an asserted valid bit. If one of the plurality of the match lines 154 is not pulled to the reference ground voltage for all the plurality of valid bits in CAM array 120, the one of the plurality of match lines 154 corresponding to a row of the CAM array 120 remains asserted to indicate a match of the logical address transferred via bus 80 occurs. However, if any of the CAM cell bits 200 pulls one of the plurality of match lines 154 to a logic low value, a corresponding one of the plurality of match lines 154 will be pulled to a logic low value if the CAM bit 200 is controlled by an asserted valid bit 128 in which transistor 262 (of **FIG. 6**) is conductive. Even when one CAM cell bit pulls a match line low, a global mismatch for that row 121 of the CAM array 120 occurs.

The match line 220 in the circuit shown in **FIGs. 6** and **7** may be precharged to VDD-VT to limit the amount of power consumed due to logic level transitions involving the match lines. A person reasonably skilled in the art will appreciate that other transistor configurations may be possible for implementing the present invention.

The CAM cell bit 200 also has power consumption advantages over prior art CAM cells which required the bit lines, b and $\overline{b}$, to vary between VDD and ground before each match operation while the match line is being precharged. Matching in CAM cell bit 200 is controlled by the *vgnd* 224 signal such that bit line transitions between VDD-VT and ground. Therefore, less power is consumed. In addition to smaller voltage swings, less power will be consumed because there is less loading on the *vgnd* signal 224 than on the data lines of prior art CAM cell bits. Power consumption savings are also gained by CAM cell bit 200 because the logical address bits supplied to the CAM array 120 are unlikely to change; therefore, bit lines 214 and 216 consume very little power consumption since they are statically driven into CAM cell bit 200.

Additionally, match lines 220 in "don't care" regions/ranges of a CAM array row 121 do not contribute to the power consumption or loading on the active portion of the match line 220. Therefore, translating addresses for page sizes which result from the assertion of fewer valid bits consume less power than page sizes which assert a larger number of valid bits.

Further, assume that the CAM array 120 and RAM array 122 have matched a logical address with a translated address. The translated address is transferred via bus 90 to multiplexer (MUX) 140 of **FIG. 5**. Page size data from the page size register 160 of the RAM array 122 and the logical address transferred via bus 80 which has been matched to the translated address provided by bus 90. The RAM array 122 may also contain attribute bits 164 concerning attributes of the memory saved in a particular physical location. The information in the attribute bits corresponds to a particular translated address may also be sent to the MUX 140. Although the RAM array 122 shown in **FIG. 5** shows separate columns for size attribute and translated address sections, the order of this information in a row 123 in the RAM array is not important as long as the distribution of this information in the array is consistent from row to row. Additionally, although **FIG. 5** shows that the size data is transferred directly to the MUX 140, it is possible that some embodiments of the invention may include an additional decoder for the size data before it is received by the MUX 140.

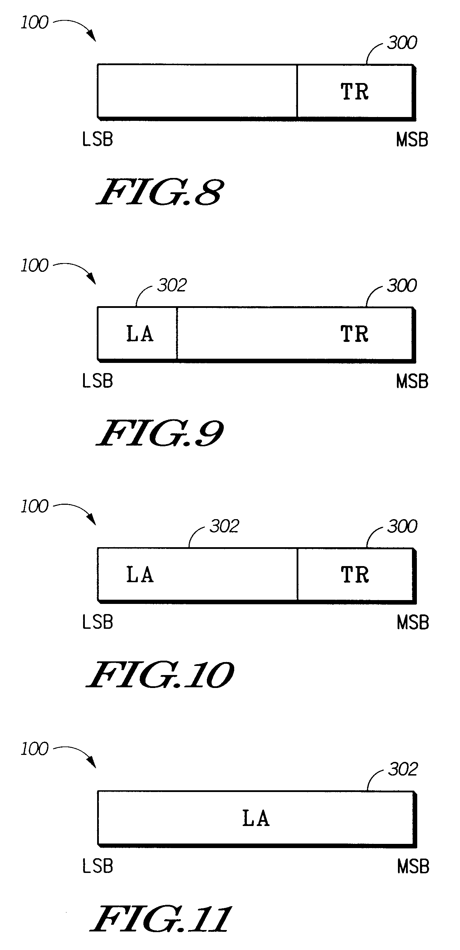

**FIG. 8** through **FIG. 11**. illustrate three examples of components of the physical address 100 output by MUX 140. They should be reviewed in conjunction with the elements illustrated on the right side of **FIG. 5**. Each example contains different mixes of a translated address value 300 , and logical address components. Once again the most significant bits of data are on the right and the least significant bits are on the left. The mix of logical address components 302 and translated address components 300 is determined by MUX 140 of **FIG. 5**. How much of the physical address 100 is composed of the logical address transferred via bus 80 passing through MUX 140 and how much of the physical address 100 is composed of the translated address transferred via bus 90 is determined by the page size stored in the page size register 160 in the RAM array 122. **FIG. 8** through **FIG. 11** illustrate four different possible page sizes of the present embodiment of the invention. If the page size is large, then more of the logical address is copied into the physical address. For example, see **FIG. 10**. **FIG. 11** illustrates the result of an identity operation when the entire logical address is passed to the physical address. If the page size is small then less of the logical address is copied into the physical address. For example, see **FIG. 8**.

The terms "asserted" and "non-asserted" are used when referring to the rendering of a signal, status bit, or similar apparatus into its logically true or logically false state, respectively. If the logically true state is a logic level one, the logically false state will be a logic level zero. And if the logically true state is a logic level zero, the logically false state will be a logic level one. Although circuits shown may imply a certain polarity or value, this implication applies only to the preferred embodiment of the invention and not all possible embodiments of the invention.

Although the present invention has been illustrated in the context of an Translation-Lookaside Buffer, the present invention may be used for operations other than address translation. It is to be understood, therefore, that this invention is not limited to the particular forms illustrated and that it is intended in the appended claims to cover all modifications that do not depart from the spirit and scope of this invention.

**Claims**

1. A data processor (10), comprising:
   interface means (24) for communicating a plurality of logical address values and a plurality of control values; and
   a memory (120) coupled to the interface means for receiving the logical address values and the control values, the memory comprising;
   a plurality of memory cells (126) coupled to the interface means for receiving the logical address values wherein each of the plurality of memory cells is composed of a plurality of memory cell bits which store a bit of a stored address value and each bit capable of selectively comparing a bit of the stored address value to a predetermined bit of the logical address value; and
   a first validity bit (128) which is coupled to the interface means for storing a first control value and which is coupled between a first portion of the plurality of memory cells and a second portion of the plurality of memory cells, the first validity bit selectively enabling each of the first portion of the plurality of memory cells to compare the bit stored therein with the predetermined bit of the logical address value.

2. The data processor of claim 1 wherein the first validity bit selectively disables each of the first portion of the plurality of memory cells from comparing the bit stored therein with the predetermined bit of the logical address value.

3. The data processor of claim 1 wherein the memory further comprises:
   a second validity bit (130) which is coupled to the interface means for storing a second control value and which is coupled between the second portion of the plurality of memory cells and a third portion of the plurality of memory cells, the second validity bit selectively enabling each of the second portions of the plurality of memory cells to compare the bit stored therein with the predetermined bit of the logical address value.

4. A data processor (10), comprising:

interface means (24)for communicating a plurality of logical address values and a plurality of control values; and

a memory coupled to the interface means for receiving the logical address values and the control values, the memory comprising;

a plurality of memory cells (126) coupled to the interface means for receiving the logical address values wherein each of the plurality of memory cells is composed of a plurality of memory cell bits which store a bit of a stored address value and each bit capable of selectively comparing a bit of the stored address value to a predetermined bit of the logical address value; and

a plurality of validity bits (128, 130, 132) which are coupled to the interface means for storing a plurality of the control values and which are coupled at least one memory cell, and the validity bits are capable of selectively enabling each memory cell bit in a memory cell with which it is coupled.

5. The data processor of claim 1 wherein the plurality of validity bits selectively disable the memory cell bits in the memory cells with which they are coupled.

6. A lookaside buffer (70) which comprises:

interface means (52, 40) for communicating a logical address value and control values; and

a CAM array (120)coupled with the interface means comprising

a plurality of CAM cell rows (121);

at least two CAM cells per row composed of a plurality of CAM cell bits (126) which can store a possible address value and compare it to a logical address value;

a conductive line for each row connected to each CAM cell bit in the row;

a plurality of validity bits (128) coupled to the CAM cells and interface means on at least one side and connected to the conductive line wherein the validity bits are capable of selectively isolating the CAM cells on at least a first side of the CAM cell bits on a second side;

a RAM array (122) coupled to the conductive line for each row of the CAM array comprising a plurality of RAM cell bits for storing a translated address; and

multiplexing means (100) connected to the interface means and the RAM array for multiplexing the logical address with the control values and the translated addresses to generate a physical address.

*FIG.1*

| | | DATA MEMORY UNIT (DMU) 32 |
|---|---|---|
| MEMORY MANAGEMENT UNIT (MMU) FIG.4 52 | TAGS 54 | DATA CACHE 56 |

## FIG.2

| | | INSTRUCTION MEMORY UNIT (IMU) 40 |
|---|---|---|
| MEMORY MANAGEMENT UNIT (MMU) FIG.4 62 | TAGS 64 | INSTRUCTION CACHE 68 |

## FIG.3

CONTROL

CONTROL REGISTER FILE — 72

CONTROL REGISTER 74

LOGICAL ADDRESS
— 80

TRANSLATION LOOK-ASIDE BUFFER (TLB) FIG.5 — SIZE

— 100

PHYSICAL ADDRESS

## FIG.4

FIG.5

EP 0 725 348 A1

**FIG.6**

**FIG.7**

EP 0 725 348 A1

*FIG.8*

*FIG.9*

*FIG.10*

*FIG.11*

European Patent
Office

**EUROPEAN SEARCH REPORT**

Application Number

EP 96 10 1054

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US-A-5 327 372 (OKA AKIHISA ET AL) 5 July 1994 | 1-5 | G06F12/10 G11C15/04 |
| Y | * abstract * <br> * column 8, line 30 - line 45 * <br> * column 9, line 42 - column 10, line 23 * <br> * figures 5,9,10 * <br> --- | 6 | |
| Y | EP-A-0 613 089 (DIGITAL EQUIPMENT CORP) 31 August 1994 | 6 | |
| A | * abstract * <br> * column 8, line 57 - column 13, line 47 * <br> * column 13, line 47 - column 15, line 8 * <br> * figures 4-6,8,9 * <br> --- | 1,4 | |
| A | GB-A-2 278 211 (MOTOROLA INC) 23 November 1994 <br> * the whole document * <br> --- | 1,4 | |
| A | EP-A-0 508 577 (IBM) 14 October 1992 <br> * abstract * <br> * column 4, line 3 - column 5, line 24 * <br> * figure 3 * <br> ----- | 1 | TECHNICAL FIELDS SEARCHED (Int.Cl.6) <br><br> G06F <br> G11C |

The present search report has been drawn up for all claims

| Place of search | Date of completion of the search | Examiner |
|---|---|---|
| BERLIN | 21 May 1996 | Masche, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)